# EUROPEAN PATENT APPLICATION

(11) **EP 1 205 980 A1**
(43) Date of publication of application: **15.05.2002**
(21) Application number: 00123490.5
(22) Date of filing: 07.11.2000
(51) Int. Cl.: H01L 29/78, H01L 21/336

(54) **A method for forming a field effect transistor in a semiconductor substrate**

(71) Applicant: Infineon Technologies AG, 81541 München (DE)
(72) Inventor: Curello, Giuseppe, 01099 Dresden (DE); Cappellani, Annalisa, 96100 Siraousa (IT)
(74) Representative: Barth, Stephan Manuel, Dr.

(57) **Abstract**

This invention provides a method forming a field effect transistor in a semiconductor substrate (1) comprising the steps of: providing said substrate (1); providing an insulating layer (5) above said substrate (1); providing a trench (10) in said insulating layer (5), said trench (10) reaching into said substrate (1) and defining a channel region (11) in the underlying substrate (1) area; providing a gate stack (20; 30; 40; 50) in said trench (10); removing said insulating layer (5) above said substrate (1) at the lateral sides of said gate stack (20; 30; 40; 50); and providing source (60) and drain (70) regions in said substrate (1) at the lateral sides of said gate stack (20; 30; 40; 50).

## Description

The present invention relates to a method for forming a field effect transistor in a semiconductor substrate.

It should be mentioned that the term semiconductor substrate as used herein is to be understood in a general form and should include all substrates known in semiconductor process technology, such as wafer substrates, layer substrates, well substrates, epitaxial substrates, etc..

Scaling down of MOSFET gate length and source/drain junction depth required for future generation integrated circuits leads inevitably to an increase in parasitic resistance and capacitance at the gate and source/drain regions and consequently degradation of device and circuit performance. New transistor architectures are then necessary to overcome this problem.

Conventionally, the parasitic resistance at source/drain regions has been reduced by using silicided contacts. This method consists in the deposition of a thin metal film of Ti or Co followed by its thermal reaction with the exposed silicon in source/drain regions as well as in gate regions to form the low resistance silicide alloy in the entire contact area. The unreacted metal layer over the spacers is then removed by a wet etch step. This is described in Metal Silicides: Active Elements of ULSI Contacts, C.M. Osburn et al., Journal of Electronic Materials, Vol. 25, No. 11, p. 1725, 1996.

For future generations, however, this method is limited by narrow line effects which result in agglomeration of the silicide thin films and by the silicon source/drain layer consumption during silicide formation. Since the junction depth is also to be scaled down in order to improve short channel effects, a shallower doped layer will be available for silicidation. This problem is also present in Fully Depleted Silicon on Insulator Technology, which is used in order to reduce parasitic junction capacitance where the silicon thickness over the insulating layer is reduced with the scaling down of the gate length.

This issue is being addressed in research laboratories by elevation of source/drain regions with respect to the silicon surface employing silicon selective epitaxy technique. In this respect, see Selective Epitaxial Si & SiGe for Elevated S/D MOSFETs, S.B. Samavedam et al., MRS 2000, Spring Meeting, San Francisco, CA, USA, April 2000, Proceedings of Symposium C: Gate Stack & Silicide Issues in Si Processing and in Drivability Improvement on Deep-SubMicron MOSFETs by Elevation of S/D regions, S. Yamakawa et al., IEEE Electron Device Letters, Vol. 20, No. 7, p. 366, July 1997. Another issue is directed to the investigation of new silicide materials which consume a less amount of silicon.

The elevated source/drain method allows shallow junctions while maintaining enough silicon available for silicidation, however epitaxy technology is complex and tools are still not mature for application in volume production environments.

Therefore, it is an object of the present invention to provide a simplified method for forming a field-effect transistor in a semiconductor substrate having an equivalent structure to the one obtained with the elevated source/drain method.

According to the present invention this object is achieved by the method defined in claim 1.

The idea underlying the present invention is the formation of the gate oxide on a silicon surface which has been etched down with respect to the source/drain regions in order to create the surface offset required for elevated source/drain CMOS. By this procedure, the epitaxial growth known from prior art can be avoided.

The process according to the present invention is very attractive, because it is able to reproduce the elevated source/drain architecture while avoiding the complexity of epitaxy methods. It is feasible since oxidation of etched silicon (vertical side-wall) has been recently successfully demonstrated even in vertical transistor technology. In this respect, see f.e. A Novel Trench DRAM Cell with a Vertical Access Transistor and Buried Strap for 4Gb/16Gb, U. Gruening et al., IEDM 1998.

Since the final gate is deposited between the inner spacers which are laterally thinner at the top, it results also in a cup-shape that is equivalent to the one achieved by selective chemical vapor deposition in T-shape gate process, but without the risk of misalignment between the selective tungsten deposition and the polysilicon. In this respect, see High-performance sub-0,1 µm CMOS with low resistance T-shape Gates fabricated by selective CVD-W, D. Hisamoto et al., Symposium on VLSI Technology 1995. This cup-shape of the gate automatically offered by the proposed process is advantageous since it increases the top silicon area available to the gate silicidation, hence resulting in a lower gate resistance, while conserving the required shorter length at the gate bottom.

Moreover, the approach according to the present invention which uses only conventional processes is easily combined with a self-aligned gate formation process which is compatible with the integration of high k dielectrics and metals in gate stacks which are also very desirable for advanced CMOS.

Finally, the process is also perfectly compatible with silicon on insulator technology.

Preferred embodiments are part of the dependent claims.

According to a preferred embodiment, an angled first implantation is performed into said substrate at respective lateral sides of said trench for providing LDD-regions in said substrate at the edges of said channel region. Here the trench serves as a mask shadowing the channel region against angled LDD implantation.

According to another preferred embodiment, spacer regions are formed at said respective lateral sides of said trench after providing said LDD-regions.

According to another preferred embodiment, said spacer regions are provided by depositing silicon oxide and anisotropically backetching said silicon oxide.

According to another preferred embodiment, a second implantation is performed into said channel region for adjusting a threshold voltage of said field effect transistor.

According to another preferred embodiment, a barrier layer and a metal layer are deposited into said trench and onto the surface of said insulating layer and thereafter polished in order to be removed from the surface of said insulating layer.

According to another preferred embodiment, said insulating layer is removed by an etching process which is selective with respect to said gate stack.

According to another preferred embodiment, said source and drain regions are formed by a third implantation using said stack as a mask above said channel region.

According to another preferred embodiment, a fourth implantation is performed into said trench for providing a well in said substrate. Also heretofore like with the second implantation for adjusting the threshold, the spacers may be used as a mask.

According to another preferred embodiment, said insulating layer above said substrate is structured as a mask for providing said trench by photolithography.

An embodiment of the present invention is illustrated in the accompanying drawings and described in detail in the following.

In the Figures:

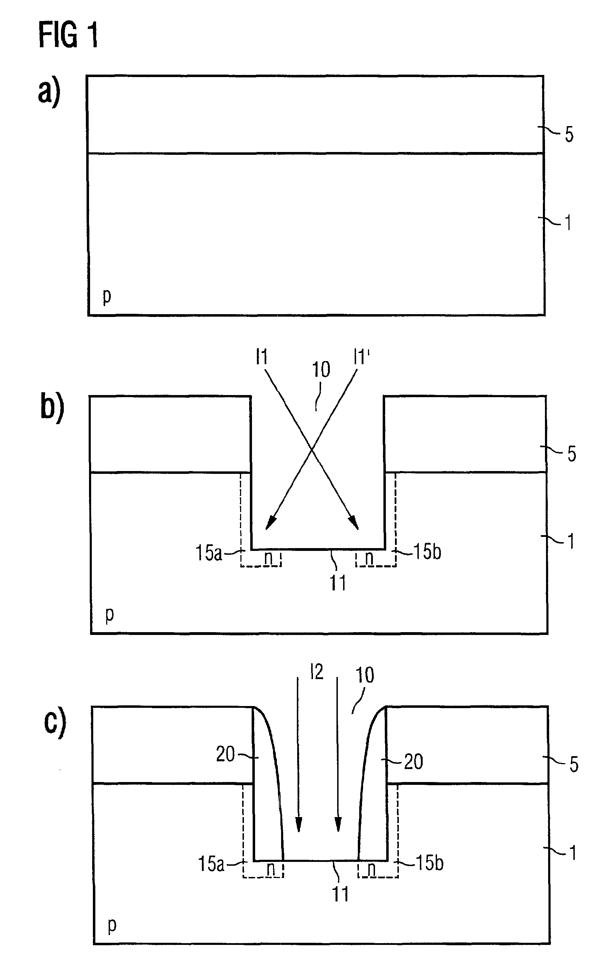

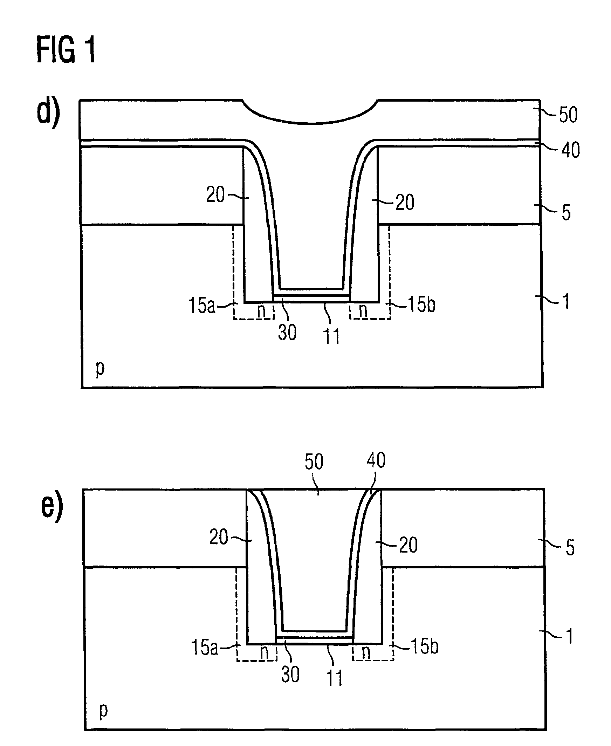

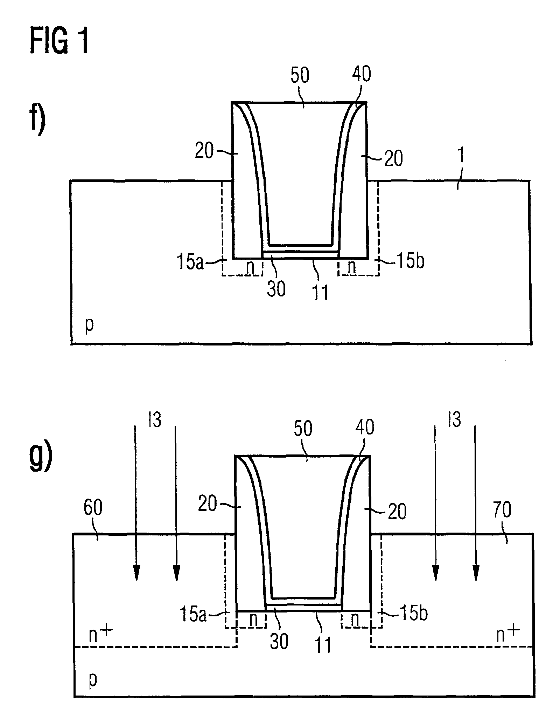

- Fig. 1a-g: show a process sequence of an embodiment of the method according to the invention for forming a field effect transistor in a semiconductor substrate.

According to Fig. 1a, a semiconductor substrate 1 of p-type conductivity is provided. This substrate 1 can be a wafer substrate or a layer substrate or a well substrate or any kind of suitable substrate. On said substrate 1, an insulating silicon nitride layer 5 is deposited. After its deposition, the nitride layer 5 is planarized. Not shown in Fig. 1a are shallow trench isolationson the lateral sides which are well known in the state of the art.

In the next step, which is illustrated with respect to Fig. 1b, a trench 10 is provided in said insulating nitride layer 5, said trench 10 reaching into said substrate 1 by a predetermined depth. The method of forming the trench 10 is for example an anisotropic etching method using a hard mask which is not shown here because it is also well known in the art. Especially the nitride and an optional underlying thin pad oxide may be structured as said hard mask.

Then, still with reference to Fig. 1b, an angled first implantation I1, I1' is performed into said substrate 1 at respective lateral sides of said trench 10 for providing LDD regions 15a, 15b in said substrate 1 at opposite edges. Inbetween said LDD regions 15a, 15b in said substrate 1, there is arranged a channel region 11 of said later field effect transistor. The trench shadows the channel region 11 against said LDD ions.

In a next step, which is illustrated with respect to Fig. 1c, a silicon oxide layer, f.e. TEOS, is deposited over the resulting structure and anisotropically etched back in order to define side-wall spacers 20 at respective sides of said trench 10 where said LDD regions 15a, 15b are located.

Then, a second implantation I2 is performed in order to adjust the threshold voltage of the channel using appropriate ions. This implantation is self-adjusting using said nitride spacer regions 20 as a mask. Optionally, said spacer 20 mask can also be used for implanting the p-well of said field effect transistor.

In a next step, which is illustrated in Fig. 1d, a thermal oxidation of the exposed surface of the substrate 1 in said trench 10 is performed in order to create an SiO₂ gate oxide. Alternatively, high k dielectrics, such a Si₃N₄, TiO₂, Ta₂O₅, ...., may be used for this purpose.

In the next step, a barrier layer 40, for example consisting of WNx or TiNx, is deposited over the resulting structure, and then the gate contact material layer 50, here W, is deposited on said barrier layer and on the surface of the surrounding structure, filling the trench 10 therewith.

Here the gate stack includes the spacer region 20, the gate oxide 30, the barrier layer 40 and the contact material layer 50.

However, there are many possibilities for providing the gate stack, for example using polysilicon for conventional polygates, polysilicon + barrier layer + metal layer for polymetal gates and barrier + metal for metal-gates.

In the case of a poly-metal gate fabrication, the polysilicon as in situ doped or implanted layer is first deposited, then recessed as commonly done in trench capacitor technology, and finally a barrier layer and a metal layer are deposited onto the recessed polysilicon prior to planarization.

In a next process step, which is illustrated with respect to Fig. 1e, a chemical mechanical polishing step is performed in order to remove the deposited gate stack material 40, 50 from the surroundings of the trench 10. This chemical mechanical polishing step stops at the insulating nitride layer 5.

In the next step, which is illustrated in Fig. 1f, a selective oxide removable etch is performed which stops on the surface of the substrate 1 leaving an elevated gate stack in the middle of Fig. 1f.

Finally, as shown in Fig. 1g, a third implantation I3 is performed for introducing source/drain impurities. Thereafter, a doping activation diffusion and a silicidation are performed in order to finish the field-effect transistor structure.

Although the present invention has been described with regard to specific embodiments, it is not limited thereto, but may be modified in many ways.

Particularly, the described materials are only examples and replaceable by other suitable materials. The same is true for the etch processes.

Also, the process may be used to provide NMOS and PMOS transistors with different gate stacks sequentially.

Moreover, the n⁺-junctions may be located above said LDD n-junctions.

### Reference Signs

- 1: semiconductor substrate
- 5: insulation layer
- 10: trench
- 11: channel region
- I1,I1',I2,I3: implantation
- 15a,15b: LDD regions
- 20: spacer regions
- 30: gate oxide
- 40: barrier layer
- 50: gate contact layer
- 60: source
- 70: drain

## Claims

1. A method forming a field effect transistor in a semiconductor substrate (1) comprising the steps of:
providing said substrate (1);
providing an insulating layer (5) above said substrate (1);
providing a trench (10) in said insulating layer (5), said trench (10) reaching into said substrate (1) and defining a channel region (11) in the underlying substrate (1) area;
providing a gate stack (20; 30; 40; 50) in said trench (10);
removing said insulating layer (5) above said substrate (1) at the lateral sides of said gate stack (20; 30; 40; 50); and
providing source (60) and drain (70) regions in said substrate (1) at the lateral sides of said gate stack (20; 30; 40; 50).

2. The method according to claim 1, wherein an angled first implantation (I1; I1') is performed into said substrate (1) at respective lateral sides of said trench (10) for providing LDD-regions (15a; 15b) in said substrate (1) at the edges of said channel region (11).

3. The method according to claim 1 or 2, wherein spacer regions (20) are formed at said respective lateral sides of said trench (10) after providing said LDD-regions (15a; 15b).

4. The method according to claim 3, wherein said spacer regions (20) are provided by depositing silicon oxide and anisotropically backetching said silicon oxide.

5. The method according to one of the preceding claims, wherein a second implantation (I2) is performed into said channel region (11) for adjusting a threshold voltage of said field effect transistor.

6. The method according to one of the preceding claims, wherein a barrier layer (40) and a metal layer (50) are deposited into said trench (10) and onto the surface of said insulating layer (5) and thereafter polished in order to be removed from the surface of said insulating layer (5).

7. The method according to one of the preceding claims, wherein said insulating layer (5) is removed by an etching process which is selective with respect to said gate stack (20; 30; 40; 50).

8. The method according to one of the preceding claims, wherein said source and drain regions (60; 70) are formed by a third implantation (I3) using said stack (20; 30; 40; 50) as a mask above said channel region (11).

9. The method according to one of the preceding claims, wherein a fourth implantation is performed into said trench (10) for providing a well in said substrate (1).

10. The method according to one of the preceding claims, wherein said insulating layer (5) above said substrate (1) is structured as a mask for providing said trench (10) by photolithography.
